(19) **Europäisches Patentamt / European Patent Office / Office européen des brevets**

(11) **EP 4 742 363 A1**

(12) # EUROPEAN PATENT APPLICATION

(43) Date of publication:
**13.05.2026 Bulletin 2026/20**

(21) Application number: **25212941.6**

(22) Date of filing: **03.11.2025**

(51) International Patent Classification (IPC):
**H01M 10/48** $^{(2006.01)}$     **G01K 7/42** $^{(2006.01)}$
**G01R 31/367** $^{(2019.01)}$     **G01R 31/389** $^{(2019.01)}$

(52) Cooperative Patent Classification (CPC):
**H01M 10/486; G01K 7/427; G01R 31/367;
G01R 31/389**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **08.11.2024 US 202418941903**

(71) Applicant: **Analog Devices International
Unlimited Company
Co. Limerick (IE)**

(72) Inventor: **Leveugle, Claire
Limerick (IE)**

(74) Representative: **Horler, Philip John
Withers & Rogers LLP
2 London Bridge
London SE1 9RA (GB)**

(54) **BATTERY THERMAL MODEL BASED ON ELECTROCHEMICAL IMPEDANCE SPECTROMETRY**

(57)    Surface temperatures for battery cells in a battery pack can be inferred or estimated using internal or core temperatures of the battery cell and a thermal model. The internal temperature may be generated using electrochemical impedance spectrometry (EIS). Delta values from the EIS estimations to the cell surface temperature may be generated based on a thermal model of the battery. The thermal model of the battery may be created using probe points on the surface of a test battery, such as thermocouples.

EP 4 742 363 A1

## Description

This application claims priority from United States patent application no. 18/941,903 filed 8 November 2024.

## TECHNICAL FIELD

The present disclosure generally relates to battery temperature monitoring, and more particularly, to a technique for estimating surface temperature of a battery using a battery thermal model.

## BACKGROUND

Rechargeable batteries, such as lithium-ion batteries, are commonly used for portable electronics and electric vehicles (EVs), as well as a variety of other applications, such military and aerospace applications. It is important to monitor the temperature of such batteries during a variety of operations, such as fast charge and rapid discharge operations, to maximize the performance of the batteries. For example, temperature monitoring enables maintenance of cell temperature within prescribed boundaries or ranges (maximum and minimum) during fast charging, limitation of current to avoid overheating during rapid discharge, and prevention of damage to a battery due to abnormal usage to ensure safety.

## SUMMARY

The disclosure describes a method to estimate a surface temperature of a battery. The method comprises receiving a first temperature estimation of a battery cell based on at least one impedance measurement from the battery cell, the first temperature estimation representing a volumetric body temperature of the battery cell; generating a delta value for the battery cell based on a thermal model; and modifying the first temperature estimation based on the delta value to generate a second temperature estimation of the battery cell.

The disclosure also describes a system comprising one or more processors of a machine; and a memory storing instructions that, when executed by the one or more processors, cause the machine to perform operations: receiving a first temperature estimation of a battery cell based on at least one impedance measurement from the battery cell, the first temperature estimation representing a volumetric body temperature of the battery cell; generating a delta value for the battery cell based on a thermal model; and modifying the first temperature estimation based on the delta value to generate a second temperature estimation of the battery cell.

This disclosure also describes a machine-readable storage medium embodying instructions that, when executed by a machine, cause the machine to perform operations: receiving a first temperature estimation of a battery cell based on at least one impedance measurement from the battery cell, the first temperature estimation representing a volumetric body temperature of the battery cell; generating a delta value for the battery cell based on a thermal model; and modifying the first temperature estimation based on the delta value to generate a second temperature estimation of the battery cell.

## BRIEF DESCRIPTION OF THE DRAWINGS

Various ones of the appended drawings merely illustrate example embodiments of the present disclosure and should not be considered as limiting its scope.

FIG. 1 illustrates a block diagram of example portions of a battery monitoring system.
FIG. 2 is a flow diagram of a method for generating surface temperature estimations.
FIG. 3 is a flow diagram of a method for generating surface temperature estimations.
FIG. 4 shows example portions of a test battery setup.
FIG. 5 is a flow diagram of a method for generating a thermal model.
FIG. 6 illustrates a block diagram of an example comprising a machine upon which any one or more of the techniques (e.g., methodologies) discussed herein may be performed.

## DETAILED DESCRIPTION

Improved techniques for surface temperature estimations of battery cells are described. Surface temperatures for battery cells in a battery pack can be inferred or estimated using internal or core temperatures of the battery cell and a thermal model. The internal temperature may be generated using electrochemical impedance spectrometry (EIS). Delta values from the EIS estimations to the cell surface temperature may be generated based on a thermal model of the battery. The thermal model of the battery may be created using probe points on the surface of a test battery, such as thermocouples.

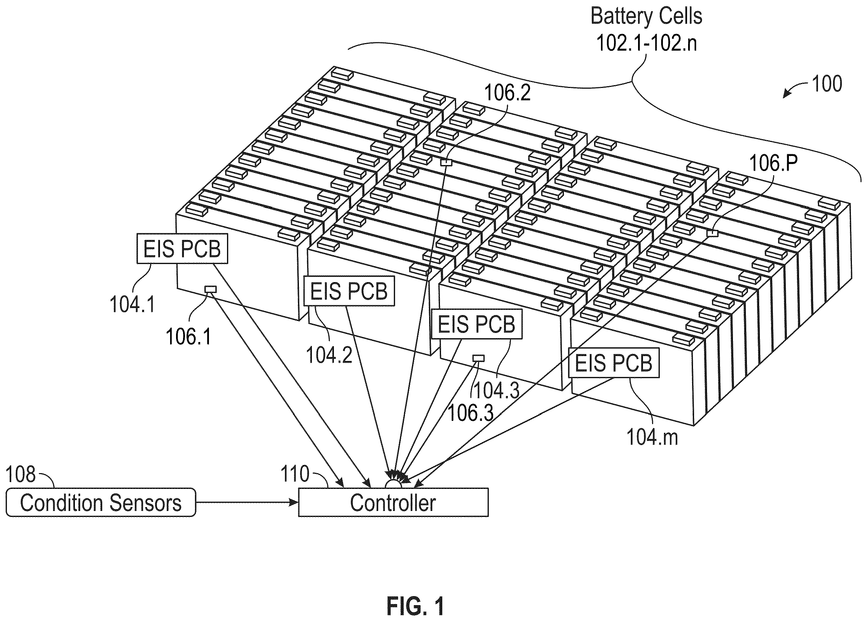

FIG. 1 illustrates a block diagram of example portions of a battery monitoring system 100. The battery monitoring system 100 includes a battery pack with a plurality of battery cells 102.1-102.n. The plurality of battery cells 102.1-102.n may be provided in different shapes, such as cube with six sides, cylindrical, etc. In the example of FIG. 1, the battery pack includes four rows of twelve battery cells resulting in a total of forty-eight battery cells.

The battery monitoring system 100 includes a electrochemical impedance spectrometry (EIS) printed circuit boards (PCBs) 104.1-104.m coupled to the plurality of battery cells 102.1-102.n. The EIS PCBs 104.1-104.m may measure impedance changes in respective battery cells 102.1-102.n. As explained in further detail below, the impedance changes are used to generate internal temperatures of the respective battery cells 102.1-102.n, also referred to as a core temperature (CoreTemp). The internal or core temperature, as used herein, refers to a volumetric body temperature of the battery cell.

The battery monitoring system 100 includes a plurality of thermocouples 106.1-106.p. The number of thermocouples 106.-1-106.p may be coupled to a select number of battery cells 102.1-102.n. In this example, only a subset of battery cells 102.-102.n (not all) may have corresponding thermocouples 106.1-106.p coupled to them. In the example of FIG. 1, four thermocouples are provided for a battery pack with forty-eight battery cells. Providing a thermocouple for each battery cell (and possibly multiple thermocouples for each battery cell) can be non-practical due to the cost and complexity of implementing the necessary thermocouple network in connection with each of the battery cells.

The battery monitoring system 100 includes one or more condition sensors 108. The condition sensors 108 may be detect a variety of different present conditions. For example, the condition sensors 108 may detect ramp/current (e.g., direct current fast charging (DCFC) ramp/current), cell location, cell swelling, oil pressure (of an EV in which the battery pack is resident), etc.

The battery monitoring system 100 includes a controller 110. The controller 110 may be provided as one or more processors, microprocessors, or the like. The controller 110 may be communicatively coupled to EIS PCBs 104.1-104.m, thermocouples 106.1-106.p, and condition sensors 108. As described in further detail below, the controller 110 may generate an internal or core temperature (CoreTemp) of respective cells based on impedance measurements received from the EIS PCBs 104.1-104.m. However, in some situations, the core temperature may not be representative of the surface temperature of the respective battery cells.

The controller 110 may also generate delta values, such as $\Delta$TSmin (delta temperature surface minimum) and $\Delta$TSmax (delta temperature surface maximum). TSmin may represent the minimum surface temperature on a face of a battery cell, and TSmax may represent the maximum surface temperature on the face of the battery cell. The delta values may be generated based on the present conditions information received from the condition sensors 108, generated core temperature based on the impedance measurements, and temperature measurements from the thermocouples 106.1-106.p.

As described in further detail below, a thermal model may be generated based using probe points on a surface of a test battery. The test battery may have the same or similar configurations as the battery cells 102.1-102.n. In some examples, the thermal model may include a compressed look up table. In some examples, the thermal model may include a polynomial function with determined coefficients. In some examples, the thermal model may include a neural network. The present values, such as condition information from the condition sensors 108, core temperature, and temperature values from thermocouples 106.1-106.p, may be inputted into the thermal model, and the thermal model may generate the delta values based on the present values.

The controller 110 may then generate surface temperature estimations based on the core temperature and delta values. For example, the minimum surface temperature (TSmin) of a battery cell may be represented as:

$$TSmin = CoreTemp + \Delta TSmin$$

The maximum surface temperate (TSmax) of a battery cell may be represented as:

$$TSmax = CoreTemp + \Delta TSmax.$$

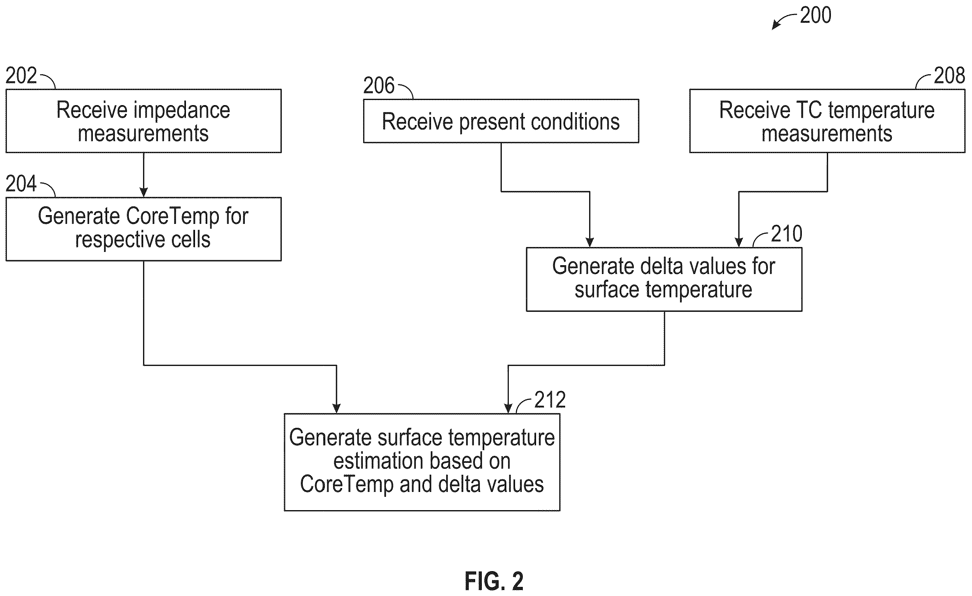

FIG. 2 is a flow diagram of a method 200 for generating surface temperature estimations. In some examples, the method 200 may be performed by the battery monitoring system 100 described above with reference to FIG. 1.

At operation 202, impedance measurements are received, for example, by a controller (controller 110). The impedance measurements may represent impedance changes in respective battery cells of the battery pack.

At operation 204, internal or core temperatures (CoreTemp) of respective cells are generated based on the impedance measurements using electrochemical impedance spectrometry (EIS) techniques. For example, a multivariable polynomial regression model can be used to estimate the internal (core) temperature of a battery using terminal impedance measurements taken at one or more frequencies of an injected sinusoidal current. In some examples, the internal or core temperatures may be generated using the techniques described in U.S. Patent Application No. 17/712,416, entitled "Technique for Estimation of Internal Battery Temperature," filed on April 4, 2022, which is incorporated herein by reference in its entirety, including but not limited to those portions that specifically appear hereinafter, the incorporation by reference being made with the following exception: In the event that any portion of the above-referenced application is inconsistent with this application, this application supersedes the above-referenced application.

At operation 206, one or more present conditions are received. The present conditions may include charging and discharging ramp/current (e.g., direct current fast charging (DCFC) ramp/current), cell location, cell swelling, oil pressure (of an EV in which the battery pack is resident), etc.

At operation 208, temperature measurements from thermocouples are received. The thermocouples may be attached to a subset of the battery cells in the battery pack (also referred to as production thermocouples). In this example, not all battery cells may have an associated thermocouple. The temperature measurements may represent surface temperatures at the location of the corresponding thermocouples.

At operation 210, delta values, such as ΔTSmin and ΔTSmax, for respective battery cells are generated based on inputting the present conditions, temperature measurements from the thermocouples, and internal (core) temperatures into a thermal model of the battery pack. The thermal model may be a 2D or 3D model. In some examples, the thermal model may be provided as a compressed look up table. Details of examples of the thermal model are described below in further detail.

At operation 212, surface temperature estimations of respective battery cells are generated based on the core temperatures and delta values. For example, the minimum surface temperature (TSmin) of a battery cell may be represented as:

$$TSmin = CoreTemp + \Delta TSmin$$

The maximum surface temperate (TSmax) of a battery cell may be represented as:

$$TSmax = CoreTemp + \Delta TSmax.$$

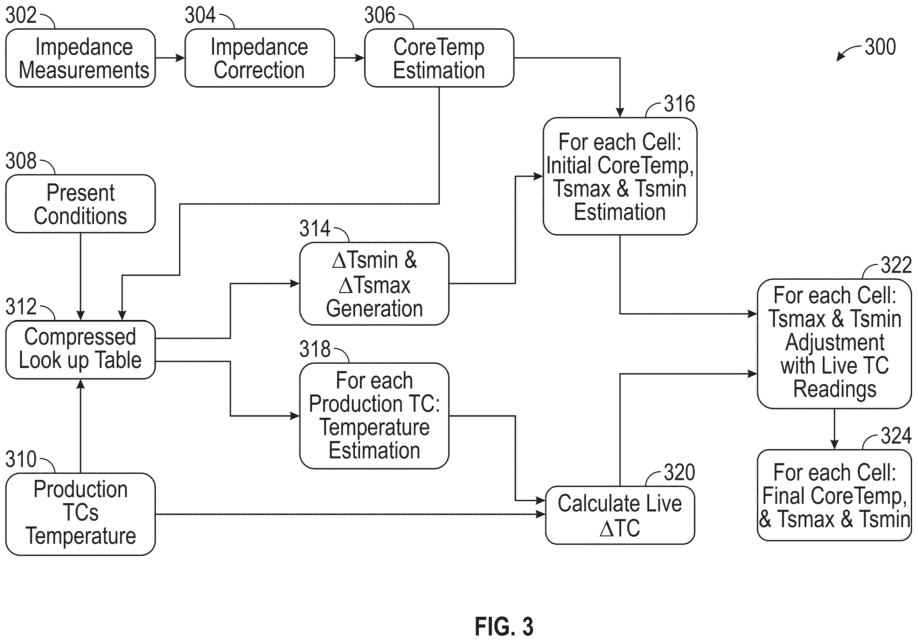

Additional fine tuning of the surface temperature estimations may also be performed. The fine tuning may be performed using present thermocouple measurements, which are coupled to a subset of battery cells. FIG. 3 is a flow diagram of a method 300 for generating surface temperature estimations. In some examples, the method 300 may be performed by the battery monitoring system 100 described above with reference to FIG. 1.

At operation 302, impedance measurements are received, for example, by a controller (controller 110). The impedance measurements may represent impedance changes in respective battery cells of the battery pack.

At operation 304, the impedance measurements are corrected. For example, the impedance measurements may include an error component and the impedance measurements may be corrected to remove the error component. In some examples, the impedance measurements may be corrected using the techniques described in U.S. Patent Application No. 18/194,495, which is incorporated herein by reference in its entirety, including but not limited to those portions that specifically appear hereinafter, the incorporation by reference being made with the following exception: In the event that any portion of the above-referenced application is inconsistent with this application, this application supersedes the above-referenced application.

At operation 306, internal or core temperatures (CoreTemp) of respective cells are generated based on the corrected impedance measurements using EIS techniques. For example, a multivariable polynomial regression model can be used to estimate the internal (core) temperature of a battery using terminal impedance measurements taken at one or more frequencies of an injected sinusoidal current. In some examples, the internal or core temperatures may be generated using the techniques described in U.S. Patent Application No. 17/712,416, entitled "Technique for Estimation of Internal Battery Temperature," filed on April 4, 2022, which is incorporated herein by reference in its entirety, including but not limited to those portions that specifically appear hereinafter, the incorporation by reference being made with the following exception: In the event that any portion of the above-referenced application is inconsistent with this application, this application supersedes the above-referenced application.

At operation 308, one or more present conditions are received. The present conditions may include DCFC ramp/current, cell location, cell swelling, oil pressure (of an EV in which the battery pack is resident), etc.

At operation 310, temperature measurements from thermocouples are received. The thermocouples may be attached to a subset of the battery cells in the battery pack. In this example, not all battery cells may have an associated thermocouple. The temperature measurements may represent surface temperatures at the location of the corresponding thermocouples.

At operation 312, the core temperature estimations, present conditions, thermocouple temperature measurements may be inputted into a thermal model of the battery pack, such as a compressed look up table. At operation 314, delta values, such as ΔTSmin and ΔTSmax, for respective battery cells are generated based on the compressed look up table.

At operation 316, initial surface temperature estimations of respective battery cells are generated based on the core temperature and delta values. For example, the minimum surface temperature (TSmin) of a battery cell may be represented as:

$$TSmin = CoreTemp + \Delta TSmin$$

The maximum surface temperate (TSmax) of a battery cell may be represented as:

$$TSmax = CoreTemp + \Delta TSmax.$$

At operation 318, TC temperature estimates are generated for the battery cells to which the thermocouples are connected based on the compressed look up table. At operation 320, delta thermocouple battery cell (ΔTC) values are generated based on the TC temperature estimate and the current live temperature measurements. For example, if the TC temperature estimate for a respective battery cell with a coupled thermocouple is 34° but the current live temperature measurement from the coupled thermocouple is 35°, then the ΔTC is +1°.

At operation 322, the initial surface temperature estimations may be adjusted based on the delta TC readings (e.g., based on ΔTC values). At operation 324, the final surface temperature and core temperature estimations may be generated for respective battery cells.

Next, details of the thermal model (e.g., compressed look up table) are described. The thermal model may be generated based on a variety of different test conditions. For example, a battery pack may be over-instrumented while being subject to various test conditions to generate values for the thermal model.

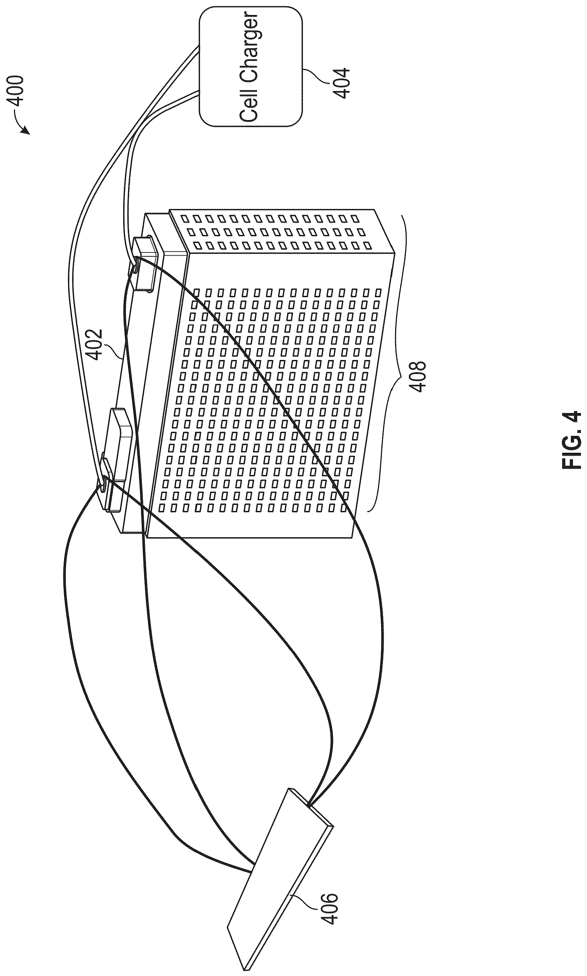

FIG. 4 shows example portions of a test battery setup 400. The test battery setup shows an example of a battery cell 402 of a test battery pack. Test battery setup 400 shows a single battery cell 402 for illustration purposes only, and the test battery setup 400 may include a plurality of battery cells, such as a full battery pack or rack.

The battery cell 402 is coupled to a cell charger 404. The cell charger 404 may control different charging and discharging conditions on the battery cell 402. Charging condition may be referred to as a Crate. A slow charger, for example, may charge at C/5 while a fast charger may charge at 4C. Discharging is related to driving conditions, such as slow and fast driving. The battery cell 402 is also coupled to an EIS PCB 406. The EIS PCB 406 may measure impedance changes in battery cell 402 during the different charging and discharging conditions. The impedance measurements may be stored and then used to generate the thermal model as described in further detail below.

The battery cell 402 is also coupled to a plurality of thermocouples 408. For example, the battery cell 402 may be coupled to tens or hundreds of thermocouples 408 in the test battery setup 400. Having these many thermocouples 408 coupled to battery cells is feasible in a test battery setup but may not be feasible in real world applications. The thermocouples 408 may measure surface temperatures at their respective locations during the different charging and discharging conditions. The surface temperature measurements may be stored and then used to generate the thermal model as described in further detail below. In some examples, a subset of the thermocouples 408 may be production thermocouples that will be used in the real-world application. In the example of FIG. 4, only one of the tens or hundreds of thermocouples 408 is a production thermocouple while the rest are added thermocouples used just in the testing environment. In a production environment, some or many cells will have no thermocouples.

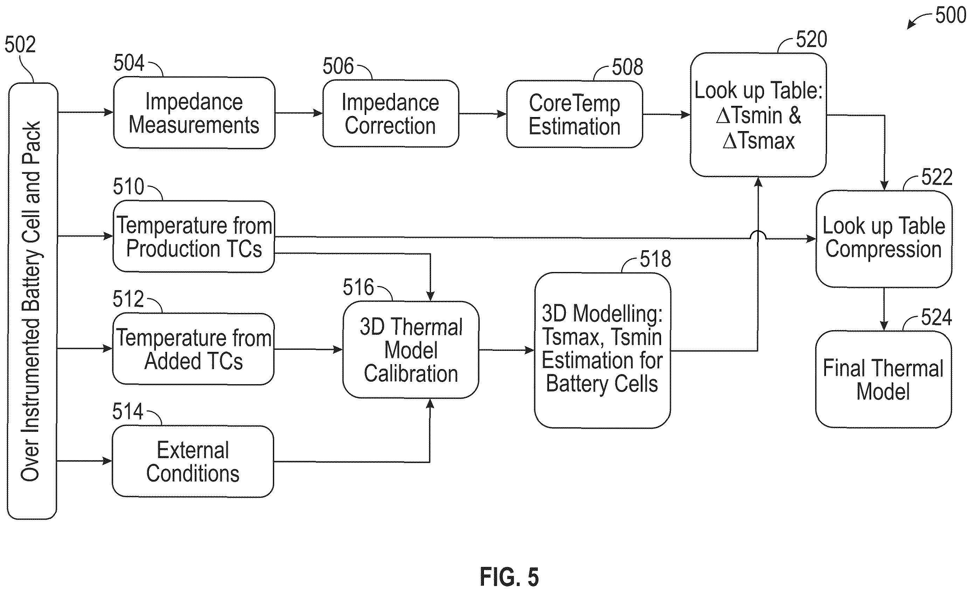

FIG. 5 is a flow diagram of a method 500 for generating a thermal model. At operation 502, an over-instrumented battery cell (and pack) is provided. For example, the test battery setup 400 as described above with reference to FIG. 4 may be provided and run.

At operation 504, impedance measurements from the test battery are received. The impedance measurements may represent impedance changes in test battery during the different charging and discharging conditions.

At operation 506, the impedance measurements are corrected. For example, the impedance measurements may include an error component and the impedance measurements may be corrected to remove the error component. In some examples, the impedance measurements may be corrected using the techniques described in U.S. Patent Application No. 18/194,495, which is incorporated herein by reference in its entirety, including but not limited to those portions that specifically appear hereinafter, the incorporation by reference being made with the following exception: In the event that any portion of the above-referenced application is inconsistent with this application, this application supersedes the above-referenced application.

At operation 508, internal or core temperatures (CoreTemp) of test battery are generated based on the corrected impedance measurements using EIS techniques. For example, a multivariable polynomial regression model can be used to estimate the internal (core) temperature of a battery using terminal impedance measurements taken at one or more frequencies of an injected sinusoidal current. In some examples, the internal or core temperatures may be generated using the techniques described in U.S. Patent Application No. 17/612,416, entitled "Technique for Estimation of Internal Battery Temperature," filed on April 4, 2022, which is incorporated herein by reference in its entirety, including but not limited to those portions that specifically appear hereinafter, the incorporation by reference being made with the following exception: In the event that any portion of the above-referenced application is inconsistent with this application, this application supersedes the above-referenced application.

At operations 510 and 512, the surface temperature measurements during the different charging and discharging conditions from the production TCs and the added TCs to the test battery are received, respectively. At operation 514, external conditions during the different charging and discharging conditions are received. The external conditions may include DCFC ramp/current, cell location, cell swelling, oil pressure (of an EV in which the battery pack is resident), etc.

At operation 516, a 3D thermal model is calibrated based on the surface properties of the test battery during the different charging and discharging conditions, such as the surface temperature measurements form the thermocouples and the external conditions. At operation 518, the 3D thermal model is finalized providing surface temperature estimations (Tsmax, Tsmin) for the test battery. In this example, the 3D thermal model is based on using probe points only on the surface of the test battery, and not internal probe points.

At operation 520, a look up table is generated based on the core temperature estimations and the 3D thermal model. For example, the temperature values from the core temperature estimation and the 3D thermal model are correlated to generate delta values, such as $\Delta TSmin$ and $\Delta TSmax$. At operation 522, the look up table is compressed. At operation 524, the final thermal model (e.g., compressed look up table) is stored. The final compressed look up table may provide $\Delta TSmin$ and $\Delta TSmax$ values for different core temperatures and other conditions. The final compressed look up table may be distributed, such as to EVs using the same or similar type of battery pack as the test battery, and can be used in real-world applications for surface temperature estimations, as described above.

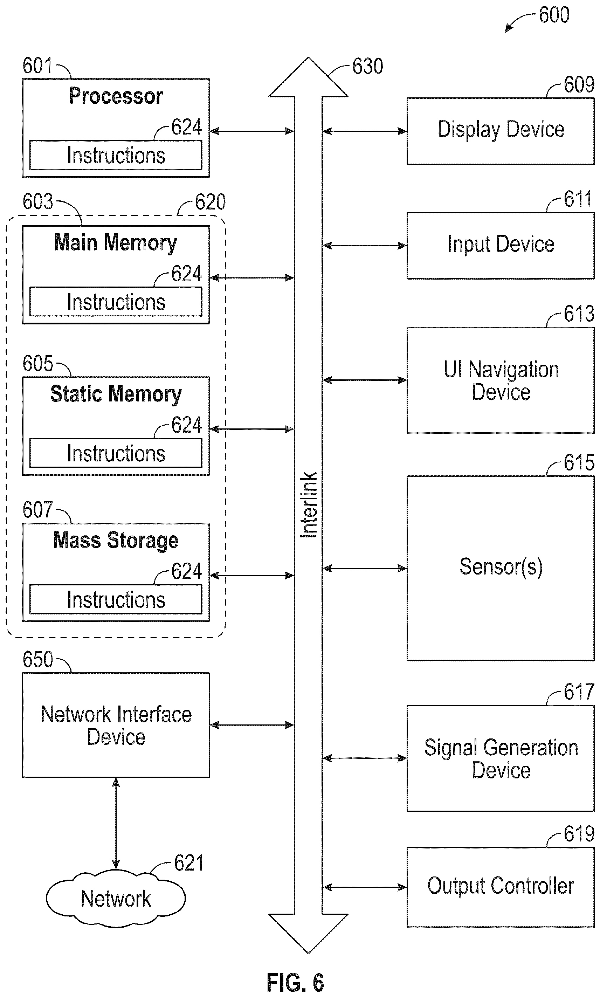

The techniques shown and described in this document can be performed using a portion or an entirety of battery monitoring system as described above or otherwise using a machine 600 as discussed below in relation to FIG. 6. FIG. 6 illustrates a block diagram of an example comprising a machine 600 upon which any one or more of the techniques (e.g., methodologies) discussed herein may be performed. In various examples, the machine 600 may operate as a standalone device or may be connected (e.g., networked) to other machines.

In a networked deployment, the machine 600 may operate in the capacity of a server machine, a client machine, or both in server-client network environments. In an example, the machine 600 may act as a peer machine in peer-to-peer (P2P) (or other distributed) network environment. The machine 600 may be a personal computer (PC), a tablet device, a set-top box (STB), a personal digital assistant (PDA), a mobile telephone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

Examples, as described herein, may include, or may operate by, logic or a number of components, or mechanisms. Circuitry is a collection of circuits implemented in tangible entities that include hardware (e.g., simple circuits, gates, logic, etc.). Circuitry membership may be flexible over time and underlying hardware variability. Circuitries include members that may, alone or in combination, perform specified operations when operating. In an example, hardware of the circuitry may be immutably designed to carry out a specific operation (e.g., hardwired). In an example, the hardware comprising the circuitry may include variably connected physical components (e.g., execution units, transistors, simple circuits, etc.) including a computer-readable medium physically modified (e.g., magnetically, electrically, such as via a change in physical state or transformation of another physical characteristic, etc.) to encode instructions of the specific operation. In connecting the physical components, the underlying electrical properties of a hardware constituent may be changed, for example, from an insulating characteristic to a conductive characteristic or vice versa. The instructions enable embedded hardware (e.g., the execution units or a loading mechanism) to create members of the circuitry in hardware via the variable connections to carry out portions of the specific operation when in operation. Accordingly, the computer-readable medium is communicatively coupled to the other components of the circuitry when the device is operating. In an example, any of the physical components may be used in more than one member of more than one circuitry. For example, under operation, execution units may be used in a first circuit of a first circuitry at one point in time and reused by a second circuit in the first circuitry, or by a third circuit in a second circuitry at a different time.

The machine 600 (e.g., computer system) may include a hardware-based processor 601 (e.g., a central processing unit (CPU), a graphics processing unit (GPU), a hardware processor core, or any combination thereof), a main memory 603 and a static memory 605, some or all of which may communicate with each other via an interlink 630 (e.g., a bus). The machine 600 may further include a display device 609, an input device 611 (e.g., an alphanumeric keyboard), and a user interface (UI) navigation device 613 (e.g., a mouse). In an example, the display device 609, the input device 611, and the UI navigation device 613 may comprise at least portions of a touch screen display. The machine 600 may additionally include a storage device 620 (e.g., a drive unit), a signal generation device 617 (e.g., a speaker), a network interface device 650, and one or more sensors 615, such as a global positioning system (GPS) sensor, compass, accelerometer, or other sensor. The machine 600 may include an output controller 619, such as a serial controller or interface (e.g., a universal serial bus (USB)), a parallel controller or interface, or other wired or wireless (e.g., infrared (IR) controllers or interfaces, near field communication (NFC), etc., coupled to communicate or control one or more peripheral devices (e.g., a printer, a card reader, etc.).

The storage device 620 may include a machine readable medium on which is stored one or more sets of data structures or instructions 624 (e.g., software or firmware) embodying or utilized by any one or more of the techniques or functions described herein. The instructions 624 may also reside, completely or at least partially, within a main memory 603, within a static memory 605, within a mass storage device 607, or within the hardware-based processor 601 during execution thereof by the machine 600. In an example, one or any combination of the hardware-based processor 601, the main memory 603, the static memory 605, or the storage device 620 may constitute machine readable media.

While the machine readable medium is considered as a single medium, the term "machine readable medium" may include a single medium or multiple media (e.g., a centralized or distributed database, and/or associated caches and servers) configured to store the one or more instructions 624.

The term "machine readable medium" may include any medium that is capable of storing, encoding, or carrying instructions for execution by the machine 600 and that cause the machine 600 to perform any one or more of the techniques of the present disclosure, or that is capable of storing, encoding or carrying data structures used by or associated with such instructions. Non-limiting machine-readable medium examples may include solid-state memories, and optical and magnetic media. Accordingly, machine-readable media are not transitory propagating signals. Specific examples of massed machine readable media may include: non-volatile memory, such as semiconductor memory devices (e.g., Electrically Programmable Read-Only Memory (EPROM), Electrically Erasable Programmable Read-Only Memory (EEPROM)) and flash memory devices; magnetic or other phase-change or state-change memory circuits; magnetic disks, such as internal hard disks and removable disks; magneto-optical disks; and CD-ROM and DVD-ROM disks.

The instructions 624 may further be transmitted or received over a communications network 621 using a transmission medium via the network interface device 650 utilizing any one of a number of transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., the Institute of Electrical and Electronics Engineers (IEEE) 802.22 family of standards known as Wi-Fi®, the IEEE 802.26 family of standards known as WiMax®), the IEEE 802.27.4 family of standards, peer-to-peer (P2P) networks, among others. In an example, the network interface device 650 may include one or more physical jacks (e.g., Ethernet, coaxial, or phone jacks) or one or more antennas to connect to the communications network 621. In an example, the network interface device 650 may include a plurality of antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding or carrying instructions for execution by the machine 600, and includes digital or analog communications signals or other intangible medium to facilitate communication of such software.

Various Notes

Each of the non-limiting aspects above can stand on its own or can be combined in various permutations or combinations with one or more of the other aspects or other subject matter described in this document.

The above detailed description includes references to the accompanying drawings, which form a part of the detailed description. The drawings show, by way of illustration, specific implementations in which the invention can be practiced. These implementations are also referred to generally as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following aspects, the terms "including" and "comprising" are open-ended, that is, a system, device, article, composition, formulation, or process that includes elements in addition to those listed after such a term in an aspect are still deemed to fall within the scope of that aspect. Moreover, in the following aspects, the terms "first," "second," and "third," etc. are used merely as labels, and are not intended to impose numerical requirements on their objects.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other implementations can be used, such as by one of ordinary skill in the art upon reviewing the above description. The Abstract is provided to allow the reader to quickly ascertain the nature of the technical disclosure. It is submitted with the understanding that it will not be used to interpret or limit the scope or meaning of the aspects. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed implementation. Thus, the following aspects are hereby incorporated into the Detailed Description as examples or implementations, with each aspect standing on its own as a separate implementation, and it is contemplated that such implementations can be combined with each other in various combinations or permutations.

ASPECTS OF THE DISCLOSURE

Non-limiting aspects of the disclosure are set of in the following numbered clauses:

1. A method to estimate a surface temperature of a battery, the method comprising:

receiving a first temperature estimation of a battery cell based on at least one impedance measurement from the battery cell, the first temperature estimation representing a volumetric body temperature of the battery cell; generating a delta value for the battery cell based on a thermal model; and modifying the first temperature estimation based on the delta value to generate a second temperature estimation of the battery cell.

2. The method of clause 1, wherein the second temperature estimation is a surface temperature estimation of the battery cell.

3. The method of any preceding clause, further comprising: receiving a present condition associated with the battery, wherein generating the delta value is further based on the present condition using the thermal model.

4. The method of any preceding clause, further comprising: receiving at least one temperature measurement from a thermocouple coupled to the battery, wherein generating the delta value is further based on the at least one temperature measurement.

5. The method of any preceding clause, wherein the delta value includes a minimum surface temperature delta value and a maximum surface temperature delta value.

6. The method of any preceding clause, wherein the thermal model includes a look up table.

7. The method of any preceding clause, wherein the thermal model is created by using probe points on a surface of a test battery.

8. The method of any preceding clause, wherein the first temperature estimation is based on an electrochemical impedance spectrometry of the at least one impedance measurement.

9. A system comprising:

one or more processors of a machine; and a memory storing instructions that, when executed by the one or more processors, cause the machine to perform operations:

receiving a first temperature estimation of a battery cell based on at least one impedance measurement from the battery cell, the first temperature estimation representing a volumetric body temperature of the battery cell; generating a delta value for the battery cell based on a thermal model; and modifying the first temperature estimation based on the delta value to generate a second temperature estimation of the battery cell.

10. The system of clause 9, wherein the second temperature estimation is a surface temperature estimation of the battery cell.

11. The system of clause 9 or clause 10, the operations further comprising: receiving a present condition associated with the battery, wherein generating the delta value is further based on the present condition using the thermal model.

12. The system of any of clauses 9 to 11, the operations further comprising:
receiving at least one temperature measurement from a thermocouple coupled to the battery, wherein generating the delta value is further based on the at least one temperature measurement.

13. The system of any of clauses 9 to 12, wherein the delta value includes a minimum surface temperature delta value and a maximum surface temperature delta value.

14. The system of any of clauses 9 to 13, wherein the thermal model includes a look up table.

15. The system of any of clauses 9 to 14, wherein the thermal model is created by using probe points on a surface of a test battery.

16. The system of any of clauses 9 to 15, wherein the first temperature estimation is based on an electrochemical impedance spectrometry of the at least one impedance measurement.

17. A machine-readable storage medium embodying instructions that, when executed by a machine, cause the machine to perform operations:

receiving a first temperature estimation of a battery cell based on at least one impedance measurement from the battery cell, the first temperature estimation representing a volumetric body temperature of the battery cell;
generating a delta value for the battery cell based on a thermal model; and
modifying the first temperature estimation based on the delta value to generate a second temperature estimation of the battery cell.

18. The machine-readable storage medium of clause 17, wherein the second temperature estimation is a surface temperature estimation of the battery cell.

19. The machine-readable storage medium of clause 17 or clause 18, further comprising:
receiving a present condition associated with the battery, wherein generating the delta value is further based on the present condition using the thermal model.

20. The machine-readable storage medium of any of clauses 17 to 19, further comprising:
receiving at least one temperature measurement from a thermocouple coupled to the battery, wherein generating the delta value is further based on the at least one temperature measurement.

## Claims

1. A method to estimate a surface temperature of a battery, the method comprising:

receiving a first temperature estimation of a battery cell based on at least one impedance measurement from the battery cell, the first temperature estimation representing a volumetric body temperature of the battery cell;
generating a delta value for the battery cell based on a thermal model; and
modifying the first temperature estimation based on the delta value to generate a second temperature estimation of the battery cell.

2. The method of claim 1, wherein the second temperature estimation is a surface temperature estimation of the battery cell.

3. The method of any preceding claim, further comprising:
receiving a present condition associated with the battery, wherein generating the delta value is further based on the present condition using the thermal model.

4. The method of any preceding claim, further comprising:
receiving at least one temperature measurement from a thermocouple coupled to the battery, wherein generating the delta value is further based on the at least one temperature measurement.

5. The method of any preceding claim, wherein the delta value includes a minimum surface temperature delta value and a maximum surface temperature delta value.

6. The method of any preceding claim, wherein the thermal model includes a look up table.

7. The method of any preceding claim, wherein the thermal model is created by using probe points on a surface of a test battery.

8. The method of any preceding claim, wherein the first temperature estimation is based on an electrochemical impedance spectrometry of the at least one impedance measurement.

9. A system comprising:

one or more processors of a machine; and
a memory storing instructions that, when executed by the one or more processors, cause the machine to perform operations:

receiving a first temperature estimation of a battery cell based on at least one impedance measurement from the battery cell, the first temperature estimation representing a volumetric body temperature of the battery cell; generating a delta value for the battery cell based on a thermal model; and modifying the first temperature estimation based on the delta value to generate a second temperature estimation of the battery cell.

10. The system of claim 9, wherein the second temperature estimation is a surface temperature estimation of the battery cell.

11. The system of claim 9 or claim 10, the operations further comprising: receiving a present condition associated with the battery, wherein generating the delta value is further based on the present condition using the thermal model.

12. The system of any of claims 9 to 11, the operations further comprising: receiving at least one temperature measurement from a thermocouple coupled to the battery, wherein generating the delta value is further based on the at least one temperature measurement.

13. The system of any of claims 9 to 12, wherein the delta value includes a minimum surface temperature delta value and a maximum surface temperature delta value.

14. The system of any of claims 9 to 13, wherein at least one of the following applies:

    (a) the thermal model includes a look up table;
    (b) the thermal model is created by using probe points on a surface of a test battery;
    (c) the first temperature estimation is based on an electrochemical impedance spectrometry of the at least one impedance measurement.

15. A machine-readable storage medium embodying instructions that, when executed by a machine, cause the machine to perform the method of any of claims 1 to 8.

FIG. 1

FIG. 2

EP 4 742 363 A1

**FIG. 3**

**FIG. 4**

EP 4 742 363 A1

FIG. 5

600

601
**Processor**

624
Instructions

603        620

**Main Memory**

624
Instructions

605
**Static Memory**

624
Instructions

607
**Mass Storage**

624
Instructions

650
Network Interface Device

621
Network

630

Interlink

609
Display Device

611
Input Device

613
UI Navigation Device

615
Sensor(s)

617
Signal Generation Device

619
Output Controller

**FIG. 6**

**EP 4 742 363 A1**

<table>
<tr><td colspan="4">Europäisches Patentamt<br>European Patent Office<br>Office européen des brevets</td><td colspan="2">**EUROPEAN SEARCH REPORT**</td><td>**Application Number**<br>EP 25 21 2941</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2022/334185 A1 (TANOVIC OMER [US] ET AL) 20 October 2022 (2022-10-20)<br>* paragraph [0019] - paragraph [0021]; figure 1b *<br>----- | 1-15 | INV.<br>H01M10/48<br>G01K7/42<br>G01R31/367<br>G01R31/389 |
| Y | DU XINGHAO ET AL: "Sensorless Temperature Estimation of Lithium-Ion Battery Based on Broadband Impedance Measurements",<br>IEEE TRANSACTIONS ON POWER ELECTRONICS INSTITUTE OF ELECTRICAL AND ELECTRONICS ENGINEERS, USA,<br>vol. 37, no. 9, 11 April 2022 (2022-04-11), pages 10101-10105, XP011909469,<br>ISSN: 0885-8993, DOI: 10.1109/TPEL.2022.3166170<br>[retrieved on 2022-04-11]<br>* page 10101, column 2 *<br>* page 10102, column 1 *<br>----- | 1-15 | |

**TECHNICAL FIELDS SEARCHED (IPC)**

H01M
G01R
G01K

The present search report has been drawn up for all claims

| Place of search | Date of completion of the search | Examiner |
|---|---|---|
| Munich | 9 March 2026 | Topalov, Angel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 2941

This annex lists the patent family members relating to the patent documents cited in the above-mentioned European search report.
The members are as contained in the European Patent Office EDP file on
The European Patent Office is in no way liable for these particulars which are merely given for the purpose of information.

09-03-2026

| Patent document cited in search report | Publication date | Patent family member(s) | Publication date |
|---|---|---|---|
| US 2022334185 A1 | 20-10-2022 | NONE | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 94190324
- US 71241622
- US 194495
- US 61241622